# EUROPEAN PATENT APPLICATION

(11) **EP 2 871 678 A1**
(43) Date of publication of application: **13.05.2015**
(21) Application number: 13191879.9
(22) Date of filing: 07.11.2013
(51) Int. Cl.: H01L 29/41, B82Y 10/00, B82Y 40/00, H01L 21/02, H01L 29/06

(54) **Method of fabrication of ordered nanorod arrays**

(71) Applicant: University College Cork, Cork City (IE)
(72) Inventor: Iacopino, Daniela, Cork (IE); Martin, Alfonso, Cork (IE)
(74) Representative: Lucey, Michael

(57) **Abstract**

The invention provides a method of fabrication of an array of metal nanorods comprising deposting an Au nanorod solution on a first substrate; evaporating the solvent; aligning the first substrate containing nanorod arrays with a second substrate; applying pressure between the first and second substrates to effect a transfer of the nanorod array from the first substrate onto the second substrate; and removing the first substrate from the second substrate such that the transferred nanorods on the second substrate forms a robust array of metal nanorods. The invention provides a method of making ordered arrays of nanorods assembled parallel or perpendicular to a substrate.

## Description

### Field

The present invention is concerned with the fabrication of nanorod arrays. More particularly, the invention is concerned with providing a fabrication technique for nanorod arrays which results in geometrically controlled and chemically stable arrays.

### Background

Synthetic procedures for forming ordered metal nanostructure arrays from droplet deposition are known. These metal nanostructures are then used in a variety of applications. One such application is surface-enhanced Raman scattering (SERS), which enables molecular chemical information to be collected.

Research has indicated that larger Raman enhancement factors than those possible from isolated metal nanostructures could be obtained through the use of aggregated nanostructures. This is due to the coupling which would occur between the localized surface plasmons of the metal nanostructures (hot spots) in the area between adjacent nanostructures. Of all the possible nanostructure shapes, the most interest has been in Au (gold) nanorods. This is because Au nanorods offer strong plasmonic fields while exhibiting excellent tunability and biocompatibility. Currently, two- and three-dimensional Au nanorod arrays obtained by droplet evaporation of Au nanorod aqueous solutions have been used to enhance SERS responses of various molecular species. However, such arrays are often characterised by irregular shape, size and thickness. This means that such arrays do not provide the chemical stability and reproducibility of results required to obtain accurate analytical results.

Accordingly, considerable efforts have been devoted in the last 10 years to the development of fabrication techniques for SERS substrates which give control over dimension, position and orientation of metal nanostructure arrays, such as imprinting lithography, step-and-flash imprinting lithography and nanotransfer printing (nTP).

Accordingly, the present invention is concerned with providing a technique for fabricating at least one metal nanostructure array which overcomes at least one of the above mentioned problems.

### Summary

Accordingly there is provided a method of fabrication of an array of metal nanorods comprising the steps of:
aligning a first substrate containing an evaporated droplet of a nanorod array with a second substrate;
applying pressure between the first and second substrates to effect a transfer of the loosely bound nanorod array from the first substrate onto the second substrate; and
removing the first substrate from the second substrate such that excess organic surfactant deposited on nanorod array can be chemically removed

The nanorod arrays, either perpendicular or parallel, are suitable for use in a variety of applications, for example SERS detection (perpendicular and parallel arrays) and anticouterfeiting tags (parallel arrays). The structures of the invention can be fabricated by a combined droplet evaporation method (known btw) and a stamping method.

In one embodiment there is provided the step of evaporating of a droplet of Au nanorod chlorobenzene solution on Si02 under controlled conditions.

In one embodiment gold nanorods form ordered arrays already upon solvent evaporation on the first substrate. The additional transfer step is needed to firmly attach arrays on a substrate and remove residual organic matter.

In one embodiment the step of washing the excess organic surfactant from the second substrate.

In one embodiment the method comprises the initial steps of:
depositing a droplet of the nanorod solution onto the first substrate; and
evaporating the droplet of the nanorod solution deposited onto the first substrate.

In one embodiment the method comprises the steps of:
synthesizing nanorods in water solution; and
performing a phase transfer of the nanorods in organic solvent prior to depositing a droplet of this nanorod solution onto the first substrate.

In one embodiment the method comprises the steps of synthesizing nanorods in water solution comprises the further steps of:
forming a seed solution;
growing of nanorods; and
overgrowing of nanorods.

In one embodiment the array of metal nanorods forms a parallel structure on the second substrate.

In one embodiment the array of metal nanorods forms a perpendicular superstructure on the second substrate.

In one embodiment the excess organic surfactant is removed by immersion in isopropanol.

In one embodiment the nanorod solution is an Au chlorobenzene solution.

In one embodiment the first substrate comprises either silicon dioxide or a glass coverslip.

In one embodiment the second substrate comprises either a glass coverslip, a PET or a PVC sheet.

In one embodiment the pressure between the first and second substrates is a pressure of 50 kg/cm² applied for 2 minutes.

In another embodiment there is provided the droplet evaporation of Au chlorobenzene solutions on the first substrate results in formation of ordered nanorod arrays. However, the arrays are obtained should adhere to the following experimental conditions:
- Au nanorod concentration in chlorobenzene is 0.1-10 nM
- CTAB concentration is below 0.2 mM
- TOAB concentration is 50 mM
- Evaporation is slowed down to 3 h by covering the droplet with a petri dish
- Humidity is about 70%

### Brief Description of the Drawings

The invention will be more clearly understood from the following description of an embodiment thereof, given by way of example only, with reference to the accompanying drawings, in which:-
Figure 1 shows a process flow of the main steps in the method of the present invention for the fabrication of Au nanorod arrays;
Figure 2 shows a block diagram illustrating the steps of the method of the present invention for the fabrication of Au nanorod arrays;
Figure 3 shows a SEM image of the parallel array (Figure 3a) and the perpendicular array (Figure 3b) formed on a substrate arising from the fabrication method of the present invention;
Figure 4a shows a comparison of the Raman spectrum of 4-aminobenzenethiol (4-ABT) powder, theSERS spectra of 4-ABT absorbed on the parallel and perpendicular arrays of the present invention and the SERS spectrum of 4-ABT adsorbed on commercial Klarite substrate while Figure 4b shows a table of the peak positions associated with the 4-ABT powder and the parallel and perpendicular superstructures;
Figure 5 illustrates variation of the relative intensity of 4-ABT C-S stretching band, v7a, with 4-ABT concentration, measured for parallel a) and perpendicular c) arrays. The red line is a log fit to the data; b,d) log plots of calibration curves shown in a,c). Red line is a linear fit to the data; and
Figure 6 illustrates a) the uniformity of perpendicular arrays calculated by measuring the variation of intensity of 4-ABT v7a band in 12 random points across a 5 mm diameter array. b) the temporal stability of the perpendicular array calculated by measuring the variation of the relative intensity of 4-ABT v7a band under 2.2 min laser continuous illumination

### Detailed Description of the Drawings

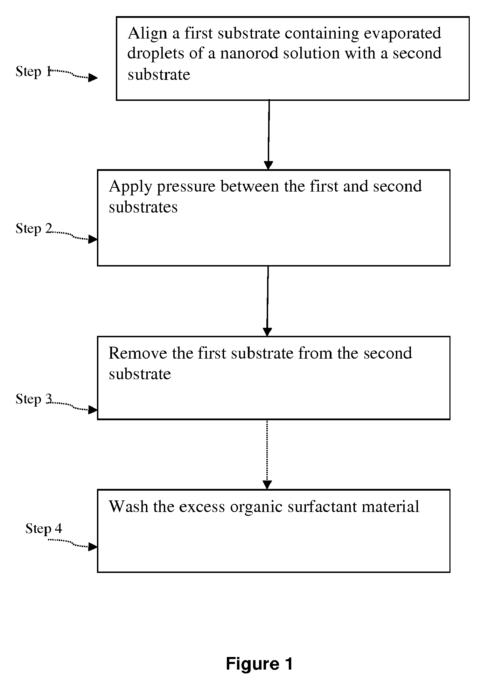

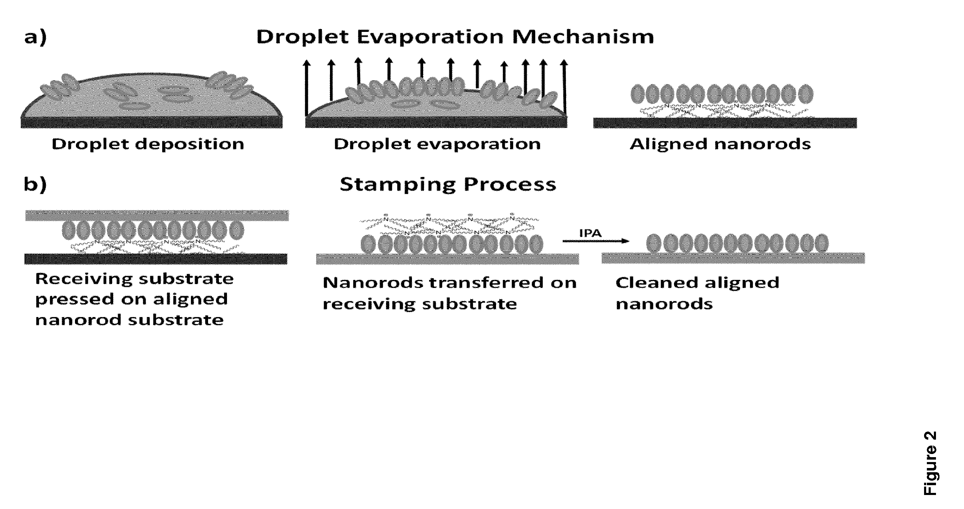

Figure 1 and 2 shows a process flow and a block diagram respectively of one embodiment of the steps of the method of the present invention for fabrication of a metal nanorod array or structure.

In step 1, a first substrate containing an array obtained from an evaporated droplet of a nanorod chlorobenzene solution, is aligned with a second substrate. In one embodiment droplet evaporation of a nanorod chlorobenzene solution on Si02 substrate is provided. Although droplet evaporation from aqueous solutions has been reported, ordered arrays obtained from organic solution deposition is new.

In step 2, pressure is applied between the first and second substrates to effect a transfer of the array from the first substrate onto the second substrate.

In step 3, the first substrate is removed from the second substrate. As a result the nanorod arrays is transferred intact onto the second substrate,

In a further step, excess organic surfactant material deposited on nanorod array is removed by immersion in isopropanol (IPA) (step 4). By washing the surface of the array with isopropanol, it removes excess CTAB and TOAB surfactants arising from the synthetic and phase transfer processes. As a result, traces of surfactant deposited in the interstices between nanorods can be removed, especially in close-packed perpendicular structures.

In the preferred embodiment of the invention, the first substrate is silicon dioxide, Si02, or a glass coverslip, while the second substrate is a glass substrate, PET or PVC sheet. Furthermore, a pressure of 50kg/cm² is applied between the two substrates for 2 minutes.

Prior to depositing the droplet of the nanorod chlorobenzene solution onto the Si02 or glass coverslip substrate, the nanorods must be first synthesized in water solution, and a phase transfer of the nanorods in organic solvent be performed. This involves four main steps, namely seed solution, growth of the nanorods (which leads to parallel arrays), over-growth of the nanorods (which leads to perpendicular arrays) and organic solvent transfer. An embodiment of one method of performing these steps is set out below.

In this embodiment, the seed solution is formed by mixing CTAB solution (5 mL, 0.20 M) with 5.0 mL of 0.50 mM HAuCl₄. To the stirred solution, 0.60 mL of ice-cold 0.010 M NaBH4 is added, which results in the formation of a pale brown solution. Vigorous stirring of the seed solution is then continued for 2 minutes after the solution is stirred, with the temperature kept at 30 °C.

Nanorods of 11 X 41 nm are then grown by adding CTAB (25 mL, 0.20 M) to 1 mL of 4 mM of AgN03 at 27 °C. To this solution, 25 mL of 0.01 mM HAuCl₄ is added, and after gentle mixing of the solution, 0.35 mL of 0.0788 M ascorbic acid is added. Ascorbic acid, being a mild reducing agent, changes the growth solution from orange to colorless. The final step is the addition of 70 µL of the seed solution at 30 °C. As a result, the color of the solution gradually changes to intense red within 10-20 minutes. The temperature of the growth solution is then kept constant at 30 °C until the growth process is complete, which typically takes between 90-120 minutes.

The nanorods are over-grown from previously synthesized nanorods. 0.0788 M ascorbic acid is added dropwise to 15 mL of nanorod solution. Additions of 5 µL/5 min are performed until spectral changes are no further detected. Usually 15 additions are necessary to overgrow nanorods, which reach20 nm in diameter and 61 nm in length.

The organic solvent transfer may be obtained by a centrifuge of the Au nanorods in water solution and a redispersion in water, so that the final CTAB concentration is lower than 0.2 mM. Mercaptosuccinic acid (3 mL, 10 mM) is added to 3 mL of aqueous nanorod solution. The pH is adjusted to 9 under vigorous stirring. To this solution 1.5 mL of TOAB chlorobenzene (50mM) is added. The resulting mixture is then left under vigorous stirring for 30 minutes until the water phase discolours and the organic phase becomes intense red.

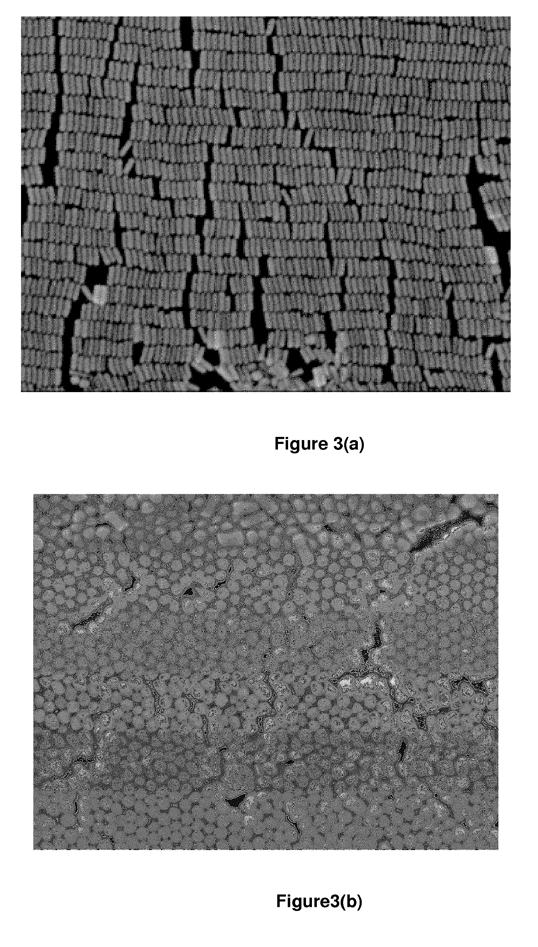

The fabricated array of the present invention provides nanorods which are either assembled parallel to the substrate in a side-by-side configuration, or perpendicular to the substrate in a hexagonal configuration. This is illustrated in Figure 3, which shows a high magnification scanning electron microscopy (SEM) image of both the parallel and perpendicular structures. The particular configuration depends on the method used for synthesis of nanorods, with grown Au nanorods resulting in a parallel array and overgrown nanorods resulting in a perpendicular array.

In Figure 3a, the SEM image of the parallel array is shown. This shows Au nanorods arranged side-by-side to form lines assembled parallel to each other in a 2D monolayer structure. In one embodiment of the invention, the parallel superstructures are obtained by droplet deposition of Au nanorods having dimensions of 11 × 41 nm, AR = 3.7, SPR = 757 nm. The average inter-nanorod distance between paralled nanorods in a line is 2.5 nm, although it can be seen that occasionally cracks along the superstructure are also observed due to the deposition process. The average internanorod distance between nanorod in adjacent lines is difficult to calculate as nanorod assemble in both perfect parallel lines or offset lines. However, an average distance of 2 nm is estimated.

In Figure 3b, the SEM image of the perpendicular superstructure is shown. In one embodiment of the invention, the perpendicular assembly is formed from droplet deposition of Au nanorods having dimensions of 20 × 61 nm, AR = 3, SPR = 785. These perpendicular Au nanorods are organized in vertical monolayers. Analogously to parallel structures, it can be seen that occasional irregularities in the lattice and formation of crack patterns may be found due to the deposition process.

The nanorod arrays fabricated in accordance with the method of the present invention are suitable for a variety of applications. In particular, they provide an ideal platform for highly sensitive SERS molecular detection. This is due to the high degree of order and the close proximity of the Au nanorods, which results in these superstructures displaying a high density of highly uniform "hot spots". This can be shown by an analysis of the SERS response of both parallel and perpendicular superstructures with 4-ABT (4-aminobenzenethiol) compared to the Raman response of commercially available Klarite substrates.

In one exemplary comparative analysis between the SERS response of both parallel and perpendicular structures with 4-ABT compared to the response of commercially available Klarite substrates, the Au nanorod arrays were immersed in 4-ABT solutions (MeOH, 0.1 mM 20 hs) and the resulting SERS spectra were compared to the normal Raman spectrum of solid 4-ABT powder measured on glass substrates.

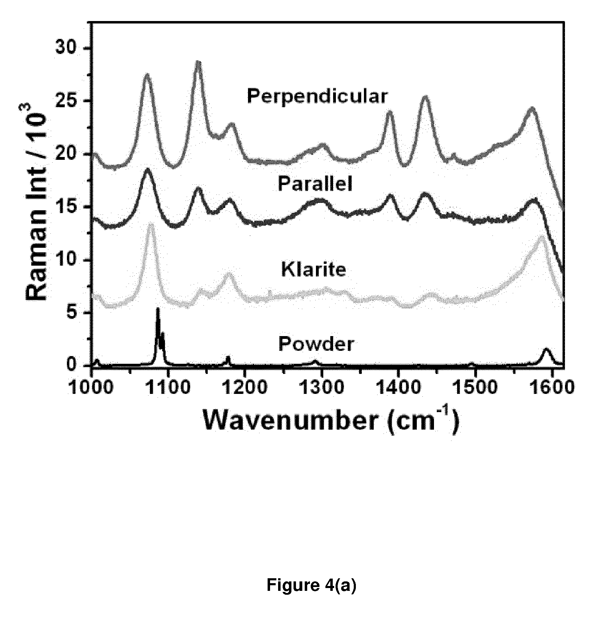

Figure 4a shows the resulting comparison of the Raman spectrum of 4-ABT powder and the SERS spectra of 4-ABT absorbed on the parallel and perpendicular superstructures. The normal Raman spectrum of 4-ABT is characterized by peaks assignable to totally symmetric (a1) vibrations, whereas the SERS spectrum shows additional peaks associated to non-totally symmetric vibrations (b2). Such vibrations are due to a metal-molecule charge transfer associated with a chemical enhancement process.

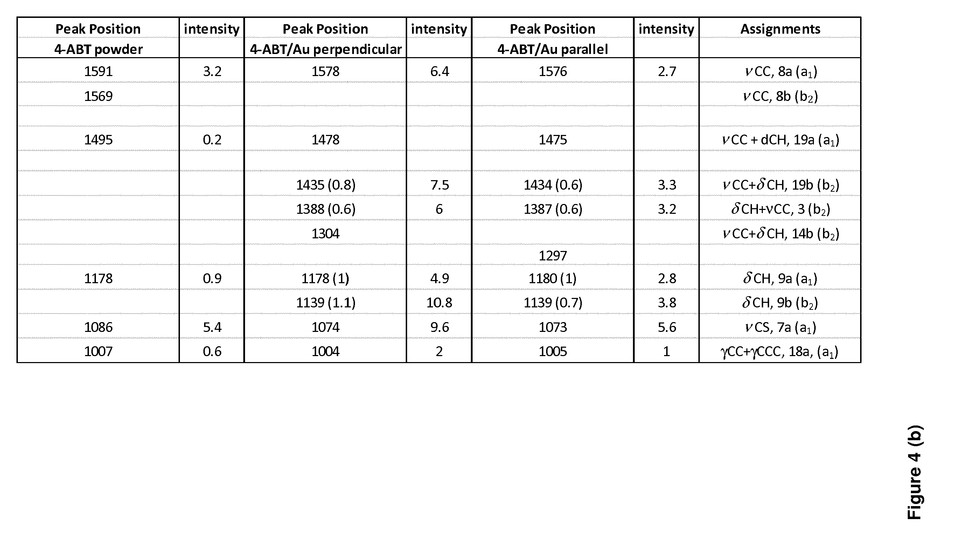

It can be seen that the Raman spectrum of solid 4-ABT is dominated by one prominent peak at 1086 which could be assigned to the C-S stretching mode. A medium peak at 1591 cm⁻¹assigned to C-C stretching modes can also be observed. The spectrum also shows two weak peaks at 1178 and 1495 cm⁻¹ assigned to pure C-H bending and a combination of C-C stretching and C-H bending, respectively. All these peaks are associated with the characteristic a₁ vibrational modes (in plane, in phase modes) of 4-ATP, as summarized in Figure 4b.

It can be seen from an analysis of the SERS spectra obtained from parallel and perpendicular superstructures exposed to 4-ABT solutions shown in Figure 4a that several additional prominent peaks are visible when compared to the previous Raman spectrum of solid 4-ABT. In particular, the two prominent modes appearing at 1086 and 1591 cm⁻¹ in the powder spectrum are also found in the SERS spectra, but shifted at 1074 and 1578 cm⁻¹ respectively in both superstructures. The weak mode originally observed at 1178 cm⁻¹ is found at 1178 and 1180 cm⁻¹ in vertical and parallel assemblies, respectively. The mode observed at 1495 cm⁻¹ in the powder spectrum is not seen in the SERS spectra indicating that this mode might be buried under the luminescence background originating from the Au substrates.

In addition, it can be seen that several new peaks are found in the SERS spectra, which are due to SERS enhancement mechanisms. These new peaks were assigned to b₂ in plane, out of phase vibrational modes. Such vibrations are due to a metal-molecule charge transfer associated to a chemical enhancement process. The enhancement of b2 modes also demonstrates that 4-ABT adopts a perpendicular orientation to the Au substrates.

In contrast, the SERS spectrum of 4-ABT absorbed on Klarite substrate showed lowe enhancement of b₂ peaks. which was attributed to a weak chemical charge-transfer process. The intensity of a₁ peaks was comparable to that recorded for the arrays.

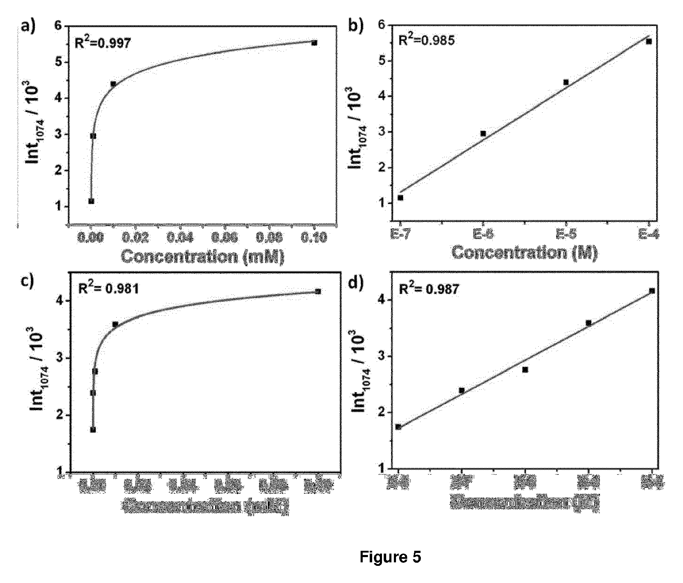

SERS detection achieved with parallel and perpendicular arrays was also used to obtain quantitative information regarding the concentration of 4-ABT in solution, as illustrated in the results shown in Figure 5 Before each spectrum acquisition, instrumentation was calibrated using an internal Si reference at 521 cm⁻¹ to ensure measurement comparability. Plots of Figure 5a,c show the intensity of the I₁₀₇₄ cm⁻¹ band against 4-ABT concentration recorded for parallel and perpendicular arrays, respectively. In both cases the signal became saturated at higher concentrations, which arose from the saturation of the active sites of the nanorod arrays. Figure 5b,c report log plots of the I₁₀₇₄ against a series of 4-ABT concentrations recorded with parallel and perpendicular arrays. In both cases a good linear relationship was found with R2 = 0.98 for parallel arrays in the concentration range 10⁻⁴ - 10⁻⁷ M and R² = 0.99 in the concentration range 10⁻⁴ - 10⁻⁸ M for perpendicular arrays, respectively.

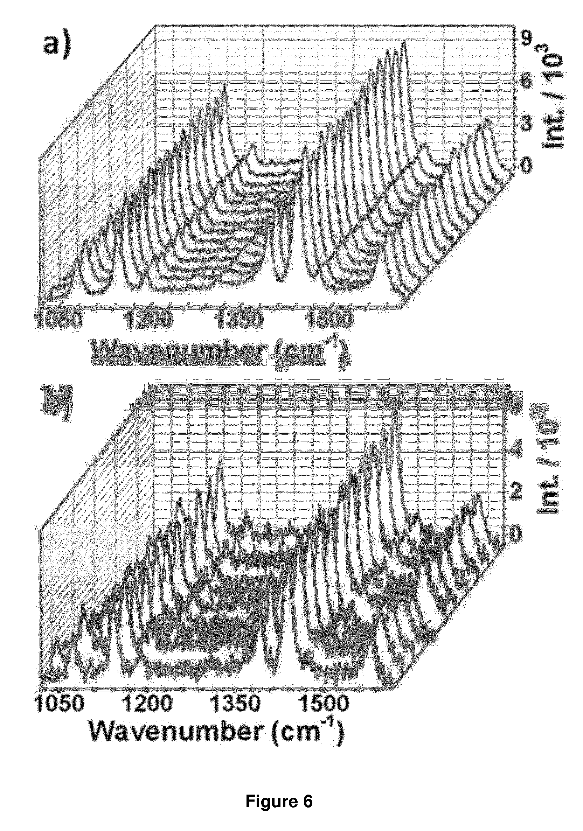

Uniformity of the fabricated arrays necessary to provide reproducible results was evaluated by measuring 12 random points over an area of 5 mm diameter of a perpendicular array and recording corresponding SERS spectra. Figure 6a shows the intensity change of the Raman bands at 1074 cm⁻¹ measured across the array. Spectra were reproducible with a calculated relative standard deviation of the intensity from 12 points of 5.9%, which showed the remarkable good uniformity of the array. Similar measurements performed on parallel arrays yielded good uniformity with SD values of 7.4% To investigate temporal stability of fabricated substrates spectra of 4-ABT (0.1 mM, MeOH) absorbed on perpendicular acid treated arrays were recorded under continuous laser irradiation for 2.2 min with laser power of 3 mW. Spectra were recoded every 2 s and the integration time was 10 s. Figure 6b shows the intensity change of the Raman bands at 1074 cm⁻¹ for 12 measurements, showing a relative standard deviation (SD) of the intensity of 6.1%. This result indicated that the array had good temporal stability under standard illumination conditions, which could meet requirements of routine SERS measurements. Analogous stability was found in parallel arrays where an SD value of 8.7% was calculated,

It will be accordingly be appreciated that both the perpendicular and parallel substrates of nanowire arrays show SERS enhancement compared to the spectrum of 4-ABT bulk. In particular, the results show that Au parallel superstructures exhibit a sharper SERS response comparable to Klarite substrates. It will therefore be appreciated that the chemical robustness and the homogeneity of the nanorod alignment within the nanorod arrays fabricated in accordance with the method of the present invention ensures reproducibility of data across substrates. These features, combined with the sharper SERS response obtained in comparison with Klarite substrates means that the structures of the present invention may be used as platforms for plasmoninduced optical molecular detection, as they are chemically robust and give high reproducibility of the SERS signal across extended areas

In addition, it will be appreciated that the fabrication of a reliable and chemically stable nanorod array on a variety of low cost and flexible substrates enables the nanorod assembly of the present invention to be suitable for wide range of molecular detection and commercial applications.

Furthermore, as the droplet evaporation that produces horizontally aligned nanorod arrays creates a unique domain pattern with unique optical signature, such applications can include encoding into QR codes and anti-clonal tags.

In the specification the terms "comprise, comprises, comprised and comprising" or any variation thereof and the terms include, includes, included and including" or any variation thereof are considered to be totally interchangeable and they should all be afforded the widest possible interpretation and vice versa.

The invention is not limited to the embodiments hereinbefore described but may be varied in both construction and detail.

## Claims

1. A method of fabrication of an array of metal nanorods comprising:
aligning a first substrate containing an evaporated droplet of a nanorod solution with a second substrate;
applying pressure between the first and second substrates to effect a transfer of the evaporated droplets from the first substrate onto the second substrate; and
removing the first substrate from the second substrate such that the transferred evaporated dropleton the second substrate forms an array of metal nanorods.

2. The method of Claim 1 comprising the step of evaporating a droplet of nanorod chlorobenzene solution on a first substrate before said aligning step.

3. The method of claim 1 or 2 further comprising the step of washing the excess organic surfactant from the second substrate.

4. The method of any of the previous claims, further comprising the initial steps of:
depositing a droplet of the nanorod solution onto the first substrate; and
evaporating the droplet of the nanorod solution deposited onto the first substrate.

5. The method of Claim 4 further comprising the steps of:
synthesizing nanorods in water solution; and
performing a phase transfer of the nanorods in organic solvent prior to depositing the droplets of this nanorod solution onto the first substrate.

6. The method of Claim 5, wherein the steps of synthesizing nanorods in water solution comprises the further steps of:
forming a seed solution;
growing the nanorods; and
overgrowing of nanorods.

7. The method of any of the previous claims, wherein the array of metal nanorods forms a parallel superstructure on the second substrate.

8. The method of any of the previous claims, wherein the array of metal nanorods forms a perpendicular superstructure on the second substrate.

9. The method of any of Claims 2 to 8, wherein the excess organic surfactant is washed by immersion in isopropanol.

10. The method of any of the preceding claims, wherein the nanorod solution is an Au chlorobenzene solution.

11. The method of any of the preceding claims, wherein the first substrate comprises either silicon dioxide or a glass coverslip.

12. The method of any of the preceding claims, wherein the second substrate comprises either a glass coverslip a PET or a PVC sheet.

13. The method of any of the preceding claims, wherein the pressure between the first and second substrates is a pressure of 50 kg/cm² applied for 2 minutes.

14. An array of metal nanorods fabricated in accordance with the method of any of Claims 1 to 13.

15. A platform for molecular optical detection based on SERS mechanisms comprising the array of metal nanorods of Clam 14.
